# EUROPEAN PATENT APPLICATION

(11) **EP 3 778 081 A1**
(43) Date of publication of application: **17.02.2021**
(21) Application number: 19777135.5
(22) Date of filing: 22.03.2019
(51) Int. Cl.: B23B 27/14, B23B 51/00, B23C 5/16, C23C 14/06

(54) **SURFACE-COATED CUTTING TOOL**

(30) Priority: 27.03.2018 JP 2018059675
(71) Applicant: Mitsubishi Materials Corporation, Tokyo 100-8117 (JP)
(72) Inventor: KINOSHITA Tatsuki, Tokyo 100-8117 (JP); HASHIMOTO Tatsuo, Tokyo 100-8117 (JP); SATO Shun, Tokyo 100-8117 (JP); SUGAWARA Yuto, Tokyo 100-8117 (JP); MAEKAWA Takuya, Tokyo 100-8117 (JP)
(74) Representative: Gille Hrabal
(86) International application number: PCT/JP2019/012095
(87) International publication number: WO 2019/188783

(57) **Abstract**

This surface-coated cutting tool includes a tool body, a lower layer, and an upper layer, the lower layer consists of a W layer, a metal carbide layer, and a metal carbonitride layer, the W layer is formed from a surface of the tool body to an inside thereof over the surface to a depth of 10 to 500 nm, the metal carbide layer includes any one of Ti, Cr, Zr, Hf, Nb, and Ta and has an average layer thickness of 5 to 500 nm, the metal carbonitride layer includes a metal contained in the metal carbide layer and has an average layer thickness of 5 to 300 nm, the upper layer has an alternate laminated structure of an A layer and a B layer and has an average total layer thickness of 1.0 to 8.0 µm, the A layer has an average layer thickness of 0.1 to 5.0 µm per one layer, and the A layer has an average composition of (AlₓCr₁₋ₓ)N (0.40 ≤ x ≤ 0.80), and the B layer has an average layer thickness of 0.1 to 5.0 µm per one layer, and the B layer has an average composition of (Al_{1-a-b-c-d}TiₐCr_{b}Si_{c}Y_{d})N (0 ≤ a ≤ 0.40, 0.05 ≤ b ≤ 0.40, 0 ≤ c ≤ 0.20, and 0.01 ≤ d ≤ 0.10).

## Description

### TECHNICAL FIELD

The present invention relates to a surface-coated cutting tool (hereinafter, also referred to as a "coated tool") which exhibits excellent chipping resistance and wear resistance without the occurrence of peeling of a hard coated layer or the like during high-speed cutting work of a Ni-based heat resistant alloy, and exhibits excellent cutting performance during long-term use.

The present application claims priority on Japanese Patent Application No. 2018-59675 filed on March 27, 2018, the content of which is incorporated herein by reference.

### BACKGROUND ART

Generally, examples of the coated tool include an indexable insert (throw away tip) used to be detachably attached to a tip portion of an insert holder in turning work or planning work of a work material such as various types of steel or cast iron, a drill or a miniature drill used in drilling cutting work of the work material, an end mill used in face milling work, grooving work, and shoulder work of the work material, and a solid hub or a pinion cutter used in toothed wheel cutting work of a tooth form of the work material.

Many proposals have been made in the related art to improve the cutting performance of coated tool.

For example, Patent Document 1 proposes a hard film having excellent wear resistance formed on a surface of a cutting tool for alloy steel and a method for forming this hard film. As the hard film having excellent wear resistance, a hard film consisting of MₐCr_{b}Al_{c}Si_{d}BₑY_{f}Z is proposed. Herein, M is at least one element selected from the group consisting of 4A group elements, 5A group elements, and 6A group elements (excluding Cr) in the periodic table and Z represents any of N, CN, NO, or CNO. Relationships of a + b + c + d + e + f = 1, 0 < a ≤ 0.3, 0.05 ≤ b ≤ 0.4, 0.4 ≤ c ≤ 0.8, 0 ≤ d ≤ 0.2, 0 ≤ e ≤ 0.2, and 0.01 ≤ f ≤ 0.1 (a, b, c, d, e, and f represent atomic ratios of M, Cr, Al, Si, B, and Y, respectively) are satisfied.

In addition, it is disclosed that, Ti can be selected as the M, the c value satisfies 0.5 ≤ c ≤ 0.8 and the f value satisfies 0.02 ≤ f ≤ 0.1, in a case where the M is Ti, and the hard film can be obtained by alternately laminating layers of compositions different from each other.

Further, it is disclosed that the hard film can be obtained by a method which includes: loading a body into an AIP apparatus; performing cleaning of the body under specific conditions with Ar ions (for example, pressure: 0.6 Pa, voltage: 500 V, time: 5 minutes); and forming a film by a cathode discharge arc ion plating method.

In addition, in order to improve durability of a coated cutting tool used in cutting work of a steel or a Ni-based heat resistant alloy, Patent Document 2 proposes a coated cutting tool including a base material, an intermediate film provided on the base material, and a hard film provided on the intermediate film. The intermediate film consists of a carbide of which the nano-beam diffraction pattern is indexed to a WC crystal structure, which contains W and Ti, and the film thickness thereof is 1 nm to 10 nm. The hard film consists of a nitride or a carbonitride having a crystal structure of a face-centered cubic lattice structure and contains at least Al, Ti and Y. A content ratio (atom%) of Al is 60% to 75%, a content ratio (atom%) of Ti is 20% to 35%, and a content ratio (atom%) of Y is 1% to 5%, in a case where a total of content ratios (atom%) of metal elements including semimetal is set to be 100%.

In order to form the intermediate film described above, it is preferable to carry out Ti bombardment by using a cathode having a magnetic field configuration in which a coil magnet is provided on an outer periphery of a target to confine an arc spot inside the target. In addition, as specific processing conditions thereof, the following conditions are preferable.

A negative bias voltage applied to the base material is set to be in a range of - 1000 V to -700 V.

A current applied to the target is set to be in a range of 80 A to 150 A.

A heating temperature of the base material before the bombardment process is set to be 450° or higher.

The Ti bombardment process is performed for 3 minutes to 7 minutes.

The Ti bombardment may be carried out while introducing argon gas, nitrogen gas, hydrogen gas, hydrocarbon gas, or the like, and the Ti bombardment is preferably carried out in a furnace atmosphere under a vacuum of 1.0×10⁻² Pa or less.

In addition, Patent Document 3 proposes a coated tool including WC-based cemented carbide as a base material and a manufacturing method therefor, in order to improve adhesion strength between the film and the base material and improve peeling resistance and wear resistance in the cutting work of alloy tool steel (SKD11).

According to Patent Document 3, this coated tool includes a W-modified phase (preferably having an average thickness of 10 to 300 nm) having a bcc structure in the crystal structure on the surface of the WC-based cemented carbide base material. The W-modified phase includes W formed through decomposition of the WC of the base material into W and C by ion irradiation of one or more metals selected from the group consisting of Ti, Zr, Hf, Nb, and Ta. A carbide phase of one or more metals selected from the group consisting of Ti, Zr, Hf, Nb, and Ta is provided directly on the W-modified phase, and a hard film is provided directly on the carbide phase. AT least one layer of this hard film is preferably a nitride containing Al and one or more elements selected from the group consisting of Ti, Cr, W, Nb, Y, Ce, Si, and B.

This coated tool can be manufactured by a first step of subjecting a base material to an ion bombardment process, and a second step of forming a hard film. In detail, the following matters are described. In the first step of performing the ion bombardment process, a negative bias voltage of -1000 to -600 (V) is applied to a base material, a mixed gas of hydrogen gas and Ar or N₂ is used at a pressure of 0.01 to 2 Pa. A volume percentage of the hydrogen gas in the mixed gas is 1% to 20%. Then, a cathode substance (one or more metals selected from the group consisting of Ti, Zr, Hf, Nb, and Ta) is evaporated from an arc discharge evaporation source. The base material is irradiated with the metal ions evaporated from the cathode substance and a surface temperature of the base material is set to be in a range of 800°C to 860°C. Accordingly, while forming a W-modified phase having a bcc structure in the crystal structure on the surface of the base material, a carbide phase of one or more metals selected from the group consisting of Ti, Zr, Hf, Nb, and Ta is formed directly on the W-modified phase and a hard film is formed directly on the carbide phase.

In recent years, factory automation (FA) of cutting work machine tools has been remarkably realized, but on the other hand, there is a strong demand for labor saving, energy saving, and cost reduction for cutting work. Along with this, cutting work tends to become even faster and more efficient, and there is a tendency for requiring a general-purpose cutting tool that enables cutting work of work materials of as many kinds as possible.

With regard to the coated tools of the related art shown in Patent Documents 1 and 3, in a case where this is used for cutting work of alloy steel, no particular problem arises. But in a case where the coated tool is used for high-speed milling and high-speed drilling of a Ni-based heat resistant alloy represented by Inconel 718 (registered trademark), for example, great thermal loads and mechanical loads are exerted to a cutting edge. In the coated tools of the related art of Patent Documents 1 and 3, the adhesion between a tool body and the hard coated layer is not sufficient. Therefore, in a case where it is used for high-speed milling and high-speed drilling of a Ni-based heat resistant alloy, abnormal damage such as peeling occurs, and due to this, the service life is reached in a short time.

In addition, in Patent Document 2, a nitride layer or carbonitride layer having a cubic crystal structure and containing at least Al, Ti, and Y is provided as a hard film, and an intermediate film formed by Ti bombardment process is provided between a tool body and the hard film. Accordingly, durability of the coated tool in cutting work of a Ni-based heat resistant alloy or the like is increased. However, in the coated tool of Patent Document 2, the adhesion between the intermediate film and the hard film is not sufficient. Accordingly, in the cutting such as the high-speed milling and the high-speed drilling of the Ni-based heat resistant alloy in which great thermal loads and mechanical loads are exerted to the cutting edge, peeling is likely to occur, and due to this, the service life is reached in a relatively short time as it is.

### PRIOR ART DOCUMENTS

### Patent Document

Patent Document 1: Japanese Patent No. 4713413
Patent Document 2: Japanese Unexamined Patent Application, First Publication No. 2017-001147
Patent Document 3: Japanese Patent No. 5098726

### DISCLOSURE OF INVENTION

### Problems to be Solved by the Invention

The invention has been made in view of the above circumstances, and an object thereof is to provide a surface-coated cutting tool in which the occurrence of peeling is prevented and abnormal damage is prevented during the high-speed cutting work of a Ni-based heat resistant alloy, and excellent cutting performance is exhibited during long-term use.

### Solutions for Solving the Problems

Therefore, from the above-described viewpoints, the inventors of the present invention have conducted intensive studies to develop a coated tool in which a hard coated layer has excellent adhesion resistance, chipping resistance, fracture resistance, and peeling resistance under the cutting work conditions of high-speed milling and high-speed drilling of a Ni-based heat resistant alloy where high-temperature heat is generated and great thermal loads and mechanical loads are exerted to a cutting edge, and the coated tool exhibits excellent wear resistance during long-term use. As a result, the following findings were obtained.

At first, with regard to the hard film disclosed in Patent Document 1 and proposed as a cutting tool for alloy steel, the inventors of the present invention have investigated applicability of this hard film as a cutting tool for a Ni-based heat resistant alloy. It was found that, in a case where the composition is represented by a composition formula: (Al_{1-a-b-c-d}TiₐCr_{b}Si_{c}Y_{d})N, a coated tool including a hard coated layer (hereinafter, may be referred to as a "(Al,Ti,Cr,Si,Y)N layer") having an average composition satisfying 0 ≤ a ≤ 0.40, 0.05 ≤ b ≤ 0.40, 0 ≤ c ≤ 0.20, and 0.01 ≤ d ≤ 0.10 (where a, b, c and d are all atomic ratios) is suitable from a viewpoint of adhesion resistance in high-speed cutting work of a Ni-based heat resistant alloy.

That is, in the above-described coated tool, in particular, the Y component contained in the hard coated layer generates a stable oxide in the outermost surface of the hard coated layer. This oxide improves the adhesion resistance. The Y component is uniformly present in the hard coated layer. Accordingly, the oxide of Y is constantly present in the outermost surface of the hard coated layer, even in a case where the cutting work is proceeded, and the adhesion resistance does not deteriorate.

However, in a case where a layer thickness of the (Al,Ti,Cr,Si,Y)N layer was excessively increased, chipping, fracture, peeling, and the like occurred; and as a result, the life of the coated tool was shortened.

Therefore, the inventors of the present invention have performed the following experiments so as to provide a coated tool exhibiting excellent wear resistance during long-term use without the occurrence of chipping, fracture, peeling, and the like. As a hard coated layer, a layer having an alternate laminated structure in which the above-described (Al,Ti,Cr,Si,Y)N layer and a composite nitride layer of Al and Cr (hereinafter, may referred to as a "(Al,Cr)N layer") were alternately laminated was manufactured. In addition, the surface of the tool body was subjected to a bombardment process disclosed in Patent Documents 2 and 3. Specifically, at first, the surface of the tool body was subjected to the bombardment process. Then, a hard coated layer having the alternate laminated structure was formed. The occurrence of chipping and fracture was prevented during the high-speed cutting work of a Ni-based heat resistant alloy, and the life of the tool was extended to some extent. However, the occurrence of peeling could not be suppressed, and it could not be said that sufficiently satisfied tool properties are obtained yet.

Therefore, the inventors of the present invention have further studied about the bombardment process shown in Patent Documents 2 and 3. The conditions of the metal ion bombardment process were changed and a lower layer having a layer structure different from that disclosed in Patent Documents 2 and 3 was formed. An effect of improving adhesion between the hard coated layer and the tool body was remarkably improved by forming a hard coated layer via the lower layer. As a result, in high-speed cutting work of a Ni-based heat resistant alloy, the occurrence of peeling could be suppressed, and at the same time, the occurrence of abnormal damage such as adhesion, chipping, and fracture could be suppressed. Accordingly, it was found that a coated tool having excellent wear resistance during long-term use can be obtained.

That is, by the inventors of the present invention, ion bombardment of any one metal selected from the group consisting of Ti, Cr, Zr, Hf, Nb, and Ta was carried out as the metal ion bombardment with respect to the tool body. The process atmosphere thereof was set to high vacuum state of 1×10⁻³ Pa or lower, a process temperature of the tool body was increased to approximately 750°C to 800°C, and the process time was increased (for example, 30 minutes to 60 minutes). As a result, a lower layer different from the lower layers disclosed in Patent Documents 2 and 3 was formed. Specifically, it was found that, by forming a lower layer consisting of a W layer, a metal carbide layer formed directly on this W layer, and a metal carbonitride layer formed directly on the metal carbide layer, adhesion between the hard coated layer and the tool body can be increased.

This lower layer is formed between the hard coated layer and the tool body. Thereby, it is possible to obtain a coated tool in which the occurrence of peeling and the occurrence of abnormal damage such as adhesion, chipping, and fracture are prevented during high-speed cutting work of a Ni-based heat resistant alloy where high-temperature heat is generated and great thermal loads and mechanical loads are exerted to a cutting edge, and the coated tool exhibits excellent cutting performance during long-term use.

An aspect of the invention has been made based on the above-described findings, and includes the following configurations.
(1) A surface-coated cutting tool including: a tool body including a tungsten carbide-based cemented carbide;
   a lower layer provided on the tool body; and
   an upper layer provided on a surface of the lower layer and having an alternate laminated structure,
   in which (a) the lower layer consists of a W layer, a metal carbide layer, and a metal carbonitride layer,
   (b) the W layer is formed from a surface of the tool body to an inside thereof over the surface to a depth of 10 to 500 nm,
   (c) a metal in the metal carbide layer is any one selected from the group consisting of Ti, Cr, Zr, Hf, Nb, and Ta, the metal carbide layer has an average layer thickness of 5 to 500 nm, and the metal carbide layer is formed directly on the W layer,
   (d) the metal carbonitride layer includes a metal component contained in the metal carbide layer, the metal carbonitride layer has an average layer thickness of 5 to 300 nm, and the metal carbonitride layer is formed directly on the metal carbide layer,
   (e) the upper layer has an alternate laminated structure in which at least one A layer and at least one B layer are alternately laminated, and the upper layer has an average total layer thickness of 1.0 to 8.0 µm,
   (f) the A layer is a composite nitride layer of Al and Cr, the A layer has an average layer thickness of 0.1 to 5.0 µm per one layer, and the A layer has an average composition satisfying 0.40 ≤ x ≤ 0.80 (where x is an atomic ratio), in a case where a composition of the A layer is represented by a composition formula: (AlₓCr₁₋ₓ)N, and
   (g) the B layer is a composite nitride layer of Al, Ti, Cr, Si, and Y, the B layer has an average layer thickness of 0.1 to 5.0 µm per one layer, and the B layer has an average composition satisfying 0 ≤ a ≤ 0.40, 0.05 ≤ b ≤ 0.40, 0 ≤ c ≤ 0.20, and 0.01 ≤ d ≤ 0.10 (where, all of a, b, c, and d are atomic ratios), in a case where a composition of the B layer is represented by a composition formula: (Al_{1-a-b-c-d}TiₐCr_{b}Si_{c}Y_{d})N.
(2) The surface-coated cutting tool according to (1), in which the surface-coated cutting tool is any one of a surface-coated insert, a surface-coated end mill, and a surface-coated drill.
(3) The surface-coated cutting tool according to (1) or (2), in which the surface-coated cutting tool is a cutting tool for cutting a Ni-based heat resistant alloy at a high speed.

### Effects of Invention

The coated tool according to an aspect of the present invention includes the lower layer and the upper layer. The lower layer consists of the W layer formed from the surface of the tool body to the inside thereof at a predetermined depth, a metal carbide layer formed on the surface of the W layer, and the metal carbonitride layer formed on the surface of the metal carbide layer. The upper layer has an alternate laminated structure in which at least one A layer consisting of an (Al,Cr)N layer and at least one B layer consisting of (Al,Ti,Cr,Si,Y)N layer are alternately laminated. The adhesion strength between the tool body and the upper layer is increased by the lower layer formed between the tool body and the upper layer. In addition, the upper layer has excellent adhesion resistance, chipping resistance, fracture resistance, and wear resistance.

Therefore, the coated tool according to an aspect of the present invention prevents the occurrence of peeling and prevents the occurrence of abnormal damage such as adhesion, chipping, and fracture, during high-speed cutting work of a Ni-based heat resistant alloy in which high-temperature heat is generated and great thermal loads and mechanical loads are exerted to a cutting edge, and the coated tool exhibits excellent cutting performance during long-term use.

### BRIEF DESCRIPTION OF DRAWINGS

FIG. 1 shows an example of a schematic vertical sectional diagram of a coated tool according to the present embodiment.
FIG. 2 shows an example of an arc ion plating apparatus used for forming an upper layer of a coated tool according to the present embodiment, in which (a) is a schematic plan view and (b) is a schematic front view. A metal target for metal ion bombardment is not shown.

### EMBODIMENTS FOR CARRYING OUT THE INVENTION

The coated tool of this embodiment will be described in detail. In the drawings used in the following description, for ease of understanding of the features, a part of feature may be enlarged for convenience, and dimensional ratios of components may not be the same as the actual dimensional ratios.

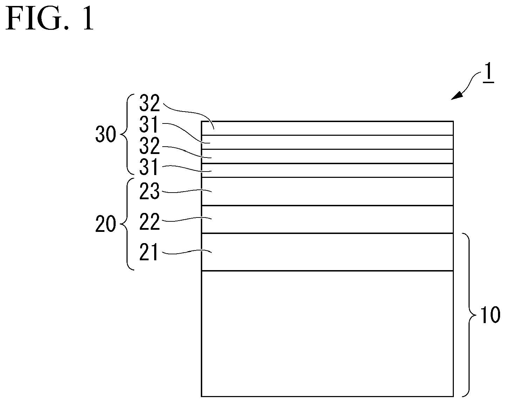

FIG. 1 shows a schematic vertical sectional diagram of a coated tool according to the present embodiment.

As shown in FIG. 1, in the coated tool 1 according to this embodiment, a lower layer 20 and an upper layer 30 having an alternate laminated structure are provided on a tool body 10 including a tungsten carbide-based cemented carbide. Specifically, the coated tool 1 according to the present embodiment includes the tool body 10, the lower layer 20 provided on the tool body 10, and the upper layer 30 provided on a surface of the lower layer 20 and having an alternate laminated structure.

The lower layer 20 consists of a W layer 21, a metal carbide layer 22, and a metal carbonitride layer 23. The W layer 21 is not formed on the surface of the tool body 10, but is formed from a surface of the tool body 10 to the inside thereof at an average depth of 10 to 500 nm. That is, the W layer 21 is provided over a region from the surface of the tool body 10 to an average depth of 10 to 500 nm. A portion of the tool body 10 other than the W layer 21 is also referred to as a tungsten carbide-based cemented carbide layer.

The metal carbide layer 22 is formed directly on the W layer 21 to have an average layer thickness of 5 to 500 nm. The metal carbonitride layer 23 is formed directly on the metal carbide layer 22 to have an average layer thickness of 5 to 300 nm. In addition, the upper layer 30 is formed on a surface of the lower layer 20 consisting of the W layer 21, the metal carbide layer 22, and the metal carbonitride layer 23. The upper layer 30 has an alternate laminated structure in which at least one A layer 31 and at least one B layer 32 are alternately laminated and has an average total layer thickness of 1.0 to 8.0 µm. Specifically, the upper layer 30 includes one or more layers of each of the A layer 31 and the B layer 32, and the A layer 31 and the B layer 32 are alternately laminated one by one.

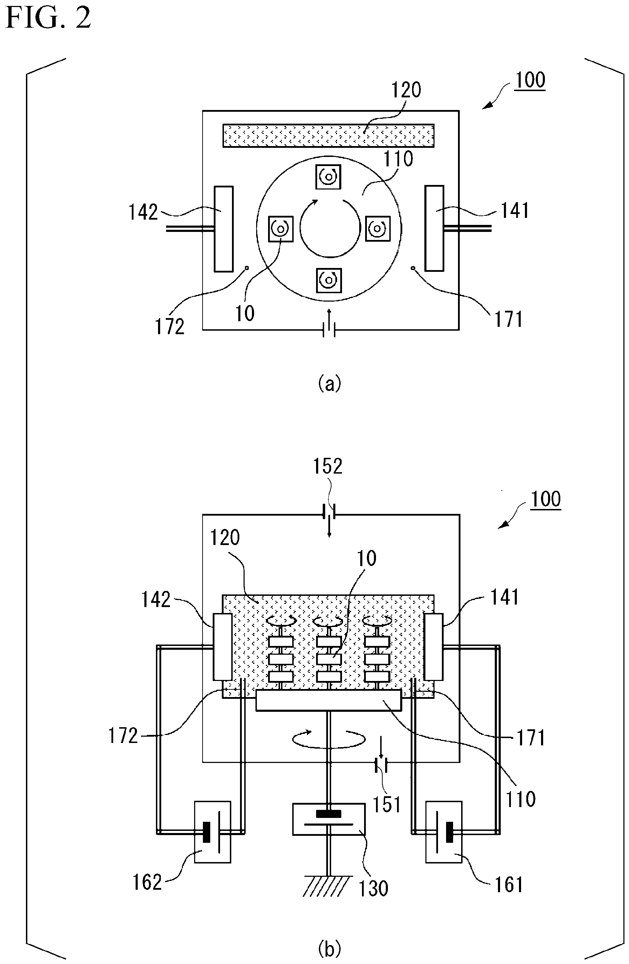

FIG. 2 shows an arc ion plating (hereinafter, referred to as "AIP") apparatus for forming a layer structure of the present embodiment. In FIG. 2, a metal target for metal ion bombardment process is not shown. A metal ion bombardment is performed under predetermined conditions with respect to a surface of the tool body 10 disposed on a rotation table 110 of the AIP apparatus 100 to form the lower layer 20 consisting of the W layer 21, the metal carbide layer 22, and the metal carbonitride layer 23. After that, the A layer 31 and the B layer 32 are alternately laminated to form the upper layer 30. As described above, the surface-coated cutting tool having the layer structure of the embodiment can be manufactured.

### Lower layer 20:

The W layer 21 and the metal carbide layer 22 configuring the lower layer 20 are both layers formed by metal ion bombardment process of the present embodiment which will be described later.

Among the above-described layers, the W layer 21 and the metal carbide layer 22 directly on the W layer 21 are formed as follows. By the metal ion bombardment (irradiation), WC at or in the vicinity of the surface of the tool body 10 is decomposed into W and C. Thereby, the W layer 21 is formed from the surface of the tool body 10 to a predetermined depth. In addition, the metal carbide layer 22 is generated on the surface of the W layer 21 due to a reaction between the ion-bombarded metal and C.

In a case where the average thickness (depth) of the W layer 21 to be formed is less than 10 nm, the metal carbide layer 22 directly thereon is not sufficiently formed, and sufficient adhesion strength with a hard layer cannot be obtained. On the other hand, in a case where the average thickness exceeds 500 nm, the hard coated layer is easily peeled off due to the embrittlement of the surface of the tool body 10. Accordingly, the average thickness (depth) of the W layer 21 formed from the surface of the tool body 10 to the inside thereof is set to be in a range of 5 or more to 500 nm or less. The average thickness (depth) of the W layer 21 is more preferably in a range of 20 nm to 300 nm.

In addition, as described above, the metal carbide layer 22 formed directly on the W layer 21 is formed by the reaction of bombarded metal ions with C obtained by decomposing WC into W and C. In a case where the average layer thickness of the metal carbide layer 22 is less than 5 nm, the thickness of the W layer 21 also becomes excessively thin and the effect of improving the adhesion to the hard layer is slight. On the other hand, in a case where the average layer thickness of the metal carbide layer 22 exceeds 500 nm, the average thickness (depth) of the W layer 21 exceeds 500 nm. Accordingly, the surface of the tool body 10 becomes brittle. Therefore, the average layer thickness of the metal carbide layer 22 formed directly on the W layer 21 is set to be in a range of 5 to 500 nm. The average layer thickness of the metal carbide layer 22 is more preferably in a range of 10 nm to 300 nm.

In addition, the metal carbonitride layer 23 is formed on the surface of the metal carbide layer 22, and the metal carbonitride layer 23 is a layer formed when the upper layer 30 is formed by vapor deposition method after the metal ion bombardment process of the embodiment. Metal ion bombardment process is performed for a long time (30 to 60 minutes) under high vacuum state to form the W layer 21 and the metal carbide layer 22. Then, the upper layer 30 is formed by vapor deposition method in a nitrogen atmosphere. Thereby, the metal carbonitride layer 23 can be formed. The metal carbonitride layer 23 contains the metal component contained in the metal carbide layer 22.

The metal carbonitride layer 23 has excellent adhesion strength to the metal carbide layer 22, and also has excellent adhesion to a hard layer formed on the surface of the metal carbonitride layer 23, particularly, the A layer 31 consisting of a composite nitride layer of Al and Cr. Therefore, the hard layer is prevented from being peeled off during high-speed cutting work of the Ni-based heat resistant alloy in which high-temperature heat is generated and great thermal loads and mechanical loads are exerted to the cutting edge. However, in a case where the average layer thickness of the metal carbonitride layer 23 is less than 5 nm, the adhesions to the metal carbide layer 22 and the A layer 31 are not sufficiently exhibited. In addition, in a case where the average layer thickness of the metal carbonitride layer 23 exceeds 300 nm, strain in the layer increases; and thereby, adhesion is decreased. Therefore, the average layer thickness of the metal carbonitride layer 23 is set to be in a range of 5 to 300 nm. The average layer thickness of the metal carbonitride layer 23 is more preferably in a range of 10 to 200 nm.

### Formation of lower layer: 20

More specifically, an example of the method for forming the lower layer 20 is as follows.

First, the tool body 10 is rotatably placed on a rotation table 110 in the AIP apparatus 100. The inner atmosphere of the apparatus is held in a high vacuum state of 1×10⁻³ Pa or less, and the temperature of the tool body 10 is increased to approximately 500°C by a heater 120. Then, the temperature of the tool body 10 is increased to approximately 750°C to 800°C, and this temperature is maintained during the bombardment process. Then, a bias voltage of approximately -1000 V is applied to the tool body 10 by a bias electric power supply 130, and a target for metal ion bombardment (for example, a Ti target) is supplied with an arc current of approximately 100 A. This process is continued for approximately 30 to 60 minutes to perform the metal ion bombardment process. Thereby, the W layer 21 is formed from the surface of the tool body 10 to a predetermined depth in the inside thereof. At the same time, the metal carbide layer 22 having a predetermined thickness is formed on the surface of the W layer 21. In addition, the metal carbonitride layer 23 is formed by a diffusion reaction between the upper layer 30 and the metal carbide layer 22 when the upper layer 30 is formed by vapor deposition.

By the method described above, the lower layer 20 consisting of the W layer 21 having a predetermined depth, the metal carbide layer 22 having a predetermined average layer thickness, and the metal carbonitride layer 23 having a predetermined average layer thickness can be formed in or on the tool body 10.

The W layer 21, the metal carbide layer 22, and the metal carbonitride layer 23 are desirably formed in layer shape in or on the tool body 10. However, for example, these layers may be preferentially formed in an island shape on the WC particles. Even in this case, the effect of improving the adhesion strength between the base material and the hard coated layer can be obtained.

As the kind of metal constituting the metal carbide layer 22, any one metal selected from the group consisting of Ti, Cr, Zr, Hf, Nb, and Ta is preferable, and Ti and Cr are particularly preferable.

When the metal constituting the metal carbide layer 22 is subjected to the ion bombardment, each of the metals is more likely to form a carbide than W. Therefore, the metal reacts with C of W and C decomposed from WC at or in the vicinity of the surface of the tool body 10. As a result, the metal carbide layer 22 is formed on the surface of the W layer 21.

The metal carbonitride layer 23 is a carbonitride layer containing a metal component contained in the metal carbide layer 22, and as the kinds of metals forming the metal carbonitride layer 23, at least one or more metal selected from the group consisting of Al, Ti, Cr, Zr, Hf, Nb, and Ta are preferable, and Ti and Cr are particularly preferable. The metal contained in the A layer 31 may be diffused and be contained in the metal carbonitride layer 23.

Since the metal carbonitride layer 23 is formed, the lattice mismatch at the boundary with the upper layer 30 is alleviated. Accordingly, the adhesion strength to the upper layer 30 is improved.

A ratio of carbon to nitrogen in the metal carbonitride layer 23 is not limited; however, the ratio of atomic concentration of nitrogen to a total atomic concentration of carbon and nitrogen is preferably 0.1 to 0.9, as an average in the metal carbonitride layer 23.

In addition, since the metal constituting the metal carbide layer 22 and the metal constituting the metal carbonitride layer 23 are the same kind of metal (for example, Ti carbide layer and Ti carbonitride layer), it is advantageous to continuously perform the metal ion bombardment process and the process of forming the metal carbonitride layer 23.

However, the metals are not limited to the same kind, and different kinds of metals may be used. In the metal ion bombardment process of the present embodiment, W particles may partially remain in the layer during the reaction process when forming the lower layer 20, but in that case, the effect of improving the adhesion of the lower layer 20 is also exhibited.

### Upper layer 30:

The upper layer 30 formed on the lower layer 20 has an alternate laminated structure in which at least one A layer 31 and at least one B layer 32 are alternately laminated, and has an average total layer thickness of 1.0 to 8.0 µm. Specifically, the upper layer 30 has one or more layers of each of the A layer 31 and the B layer 32, and the A layer 31 and the B layer 32 are alternately laminated one by one.

The A layer 31 is a composite nitride (hereinafter, may be referred to as a "(Al,Cr)N") layer of Al and Cr having an average layer thickness of 0.1 to 5.0 µm per one layer, and has an average composition satisfying 0.40 ≤ x ≤ 0.80 (where x is an atomic ratio), in a case where a composition thereof is represented by a composition formula: (AlₓCr₁₋ₓ)N.

In addition, the B layer 32 is a composite nitride ("(Al,Ti,Cr,Si,Y)N") layer of Al, Ti, Cr, Si, and Y having an average layer thickness of 0.1 to 5.0 µm per one layer and has an average composition satisfying 0 ≤ a ≤ 0.40, 0.05 ≤ b ≤ 0.40, 0 ≤ c ≤ 0.20, and 0.01 ≤ d ≤ 0.10 (where, all of a, b, c, and d are atomic ratios), in a case where a composition thereof is represented by a composition formula: (Al_{1-a-b-c-d}TiₐCr_{b}Si_{c}Y_{d})N.

A value of N/(Al+Cr+N) in the composition formula for the A layer 31 and a value of N/(Al+Ti+Cr+Si+Y+N) in the composition formula for the B layer 32 do not necessarily have to be the stoichiometric ratio of 0.5. Excluding elements such as carbon and oxygen which are inevitably detected due to the influence of contamination on the surface of the tool body 10, the atomic ratios of the content ratios of Al, Cr, and N are quantified, and the atomic ratios of content ratios of Al, Ti, Cr, Si, Y, and N are also quantified. In a case where the value of N/(Al+Cr+N) or the value of N/((Al+Ti+Cr+Si+Y+N) is in a range of 0.45 to 0.65, there is no particular problem, since the effect equivalent to that of the A layer 31 or the B layer 32 in which the value is the stoichiometric ratio of 0.5 is obtained.

### (Al,Cr)N layer constituting A layer 31 of upper layer 30:

In a case where an average layer thickness per one layer of the A layer 31 consisting of the (Al,Cr)N layer is less than 0.1 µm, the effect of improving wear resistance and the effect of improving fracture resistance are insufficient. On the other hand, in a case where the average layer thickness per one layer thereof exceeds 5.0 µm, the internal strain in the A layer 31 increases and the A layer easily breaks. Accordingly, the average layer thickness per one layer of the A layer 31 is set to be in a range of 0.1 to 5.0 µm. The average layer thickness per one layer of the A layer 31 is preferably 0.5 to 3.0 µm.

In addition, in the composition formula of the A layer 31: (AlₓCr₁₋ₓ)N, in a case where an x value indicating an average composition ratio of Al is less than 0.40, the adhesion strength between the metal carbonitride layer 23 of the lower layer 20 and the A layer 31 and the adhesion strength between the A layer 31 and the B layer 32 increase, whereas high-temperature hardness and high-temperature oxidation resistance of the A layer 31 decrease. On the other hand, in a case where the x value exceeds 0.80, crystal grains having a hexagonal crystal structure are likely to be formed, the hardness of the A layer 31 is decreased, and sufficient wear resistance cannot be obtained.

Therefore, the x value indicating the average composition ratio of Al is set to satisfy 0.40 ≤ x ≤ 0.80. The x value indicating the average composition ratio of Al is preferably set to satisfy 0.50 ≤ x ≤ 0.75. The average composition ratio x of the Al component in the A layer 31 can be obtained by measuring the content of the Al component at a plurality of portions (for example, 5 portions) in the vertical section of the A layer 31 using SEM-EDS and averaging the measured values.

### (Al,Ti,Cr,Si,Y)N layer constituting B layer 32 of upper layer 30:

In the (Al,Ti,Cr,Si,Y)N layer constituting the B layer 32 of the upper layer 30, the Al component has an effect of improving high-temperature hardness and heat resistance. The Ti component has an effect of improving high-temperature hardness. The Cr component has an effect of improving high-temperature toughness and high-temperature strength. In addition to these effects, an effect of improving high-temperature oxidation resistance is exhibited in a state where Al and Cr are contained together. In addition, the Si component has an effect of improving heat plastic deformation resistance. Further, Y component has an effect of increasing adhesion resistance and also oxidation resistance, as described above.

However, in a case where the a value (atomic ratio), which indicates the content ratio of Ti to a total content of Al, Ti, Cr, Si, and Y in the (Al,Ti,Cr,Si,Y)N layer, exceeds 0.40, the durability of the coated tool 1 is decreased due to a relative decrease in the Al content ratio. Accordingly, the value a is set to be in a range of 0 to 0.40.

In addition, in a case where the b value (atomic ratio) indicating the content ratio of Cr is less than 0.05, it is not possible to ensure high-temperature toughness and high-temperature strength which are at least required. Accordingly, it is not possible to prevent the occurrence of chipping and fracture. On the other hand, in a case where the b value thereof exceeds 0.40, the progress of wear is promoted due to the relative decrease in the Al content ratio. Accordingly, the b value is set to be in a range of 0.05 to 0.40.

In a case where the c value (atomic ratio) indicating the content ratio of Si exceeds 0.20, the improvement in heat plastic deformation resistance is saturated, while the effect of improving the wear resistance tends to decrease. Accordingly, the c value is set to be in a range of 0 to 0.20.

In a case where the d value (atomic ratio) indicating the content ratio of Y is less than 0.01, the effect of improving the adhesion resistance and the oxidation resistance cannot be expected. On the other hand, in a case where the d value thereof exceeds 0.10, AlN having a hexagonal crystal structure is generated and the hardness of the B layer 32 decreases. Accordingly, the d value is set to be in a range of 0.01 to 0.10.

The desirable ranges of a, b, c, and d are 0.10 ≤ a ≤ 0.30, 0.10 ≤ b ≤ 0.30, 0.05 ≤ c ≤ 0.15, and 0.05 ≤ d ≤ 0.08.

In a case where an average layer thickness per one layer of the B layer 32 consisting of the (Al,Ti,Cr,Si,Y)N layer is less than 0.1 µm, it is not possible to exhibit excellent wear resistance during long-term use. On the other hand, in a case where the average layer thickness per one layer thereof exceeds 5.0 µm, chipping and fracture are likely to occur. Accordingly, the average layer thickness per one layer of the B layer 32 consisting of the (Al,Ti,Cr,Si,Y)N layer is set to be in a range of 0.1 to 5.0 µm. The average layer thickness per one layer of the B layer 32 is preferably 1.5 to 5.0 µm. Each of the average compositions ratios a, b, c, and d of the Ti component, the Cr component, the Si component, and the Y component in the B layer 32 can be obtained by measuring a content of each component at a plurality of portions (for example, 5 portions) in the vertical section of the B layer 32 using SEM-EDS and averaging the measured values.

### Average total layer thickness of upper layer 30:

As described above, the average layer thickness per one layer of the A layer 31 and the average layer thickness per one layer of the B layer 32 are each set to be in a range of 0.1 to 5.0 µm, and the upper layer 30 has a laminated structure in which at least one A layer 31 and at least one B layer 32 are alternately laminated. An average total layer thickness of the upper layer 30 is 1.0 to 8.0 µm. The average total layer thickness of the upper layer 30 is preferably 3.0 to 6.0 µm.

In a case where the average total layer thickness of the upper layer 30 is less than 1.0 µm, it is not possible to exhibit excellent wear resistance during long-term use. On the other hand, in a case where the average total layer thickness thereof exceeds 8.0 µm, the upper layer 30 is likely to cause abnormal damage such as chipping, fracture, and peeling.

The adhesion strength between the A layer 31 and the metal carbonitride layer 23 of the lower layer 20 is high and the adhesion strength between the A layer 31 and the B layer 32 is also high. Therefore, when the upper layer 30 is formed on the surface of the lower layer 20, it is desirable to provide the A layer 31 of the upper layer 30 directly on the metal carbonitride layer 23 of the lower layer 20.

### EXAMPLES

The coated tool of the present embodiment will be described more specifically using examples.

### (Example 1)

As raw material powders, a WC powder, a TiC powder, a VC powder, a TaC powder, an NbC powder, a Cr₃C₂ powder, and a Co powder, all of which had an average grain size of 0.5 to 5 µm, were prepared. The raw material powders were mixed to have blending compositions shown in Table 1. Wax was further added thereto, and the mixture was mixed in acetone by a ball mill for 24 hours. The mixture was dried under reduced pressure. Thereafter, the resultant was subjected to press forming at a pressure of 98 MPa to obtain a green compacts having predetermined shapes. These green compacts were held at a predetermined temperature in a range of 1370°C to 1470°C in a vacuum at 5 Pa for one hour; and thereby, the green compacts were subjected to vacuum sintering. After the sintering, a cutting edge portion was subjected to honing; and thereby, tool bodies (inserts) 1 to 4 made of WC-based cemented carbide with insert shapes according to ISO · CNMG120408 were manufactured.

A lower layer and an upper layer were formed on each of the tool bodies (inserts) 1 to 4 by the following steps to manufacture surface-coated inserts 1 to 8 of the present embodiment (hereinafter referred to as tools of invention examples 1 to 8).
Step (a):
   The tool bodies 1 to 4 described above were subjected to ultrasonic cleaning in acetone and were dried. The tool bodies 1 to 4 in this dried state were mounted along outer circumferential portions on a rotation table 110 in the AIP apparatus 100 shown in FIG. 2 at positions distant from the center axis thereof by predetermined distances in a radial direction thereof. A target (evaporation source, cathode electrode) 141 consisting of an Al-Cr alloy having a predetermined composition was disposed on one side of the AIP apparatus 100, and a target (evaporation source, cathode electrode) 142 consisting of an Al-Ti-Cr-Si-Y alloy having a predetermined composition was disposed on the other side thereof.
Step (b):
   At first, the atmosphere in the apparatus was held in a vacuum (1×10⁻³ Pa or lower) by exhausting the air in the apparatus from an exhaust gas outlet 151. While maintaining the atmosphere in vacuum, the tool body that was rotated while being revolved on the rotation table 110 was sequentially heated with a heater 120 to a predetermined temperature (tool body temperature during bombardment process) shown in Table 2 from approximately 500°C. A bias voltage shown in Table 2 was applied to the tool body by the bias electric power supply 130, the arc current shown in Table 2 flowed between the tool body and the target for metal ion bombardment (for example, Ti). The tool body was subjected to the metal ion bombardment process for a process time shown in Table 2 to form the lower layer shown in Table 4.
Step (c):
   Next, nitrogen gas as a reaction gas was introduced into the apparatus to obtain the nitrogen partial pressure shown in Table 3 from a reaction gas inlet 152. While maintaining the atmosphere in this apparatus, a temperature of the tool body that was rotated while being revolved on the rotation table 110 was held in a temperature range shown in Table 3. At the same time, a DC bias voltage shown in Table 3 was applied by the bias electric power supply 130, and a current of 150 A flowed between the Al-Cr alloy target 141 and a first anode electrode 171 by the first arc electric power supply 161; and thereby, arc discharge was generated. As described above, the A layer having the composition and the average layer thickness per one layer shown in Table 4 was formed by vapor deposition on the surface of the tool body.
Step (d):
   Next, nitrogen gas as a reaction gas was introduced into the apparatus to obtain the nitrogen partial pressure shown in Table 3 from a reaction gas inlet 152. While maintaining the atmosphere in this apparatus, a temperature of the tool body that was rotated while being revolved on the rotation table 110 was held in a temperature range shown in Table 3. At the same time, a DC bias voltage shown in Table 3 was applied by the bias electric power supply 130, and a current of 150 A flowed between the Al-Ti-Cr-Si-Y alloy target 142 and a second anode electrode 172 by the second arc electric power supply 162; and thereby, arc discharge was generated. As described above, the B layer having the composition and the average layer thickness per one layer shown in Table 4 was formed by vapor deposition on the surface of the tool body.
Step (e):
   Next, the above (c) and (d) were repeated until the average total layer thickness of the upper layer was reached.
   The tools of invention examples 1 to 8 shown in Table 4 were manufactured by the steps (a) to (e).

In addition, in the condition type of invention example 1, the lower layer and the upper layer were formed under the conditions of invention examples of the lower layer formation type 1 and the upper layer formation type 1. As described above, in each condition type of invention example, the lower layer and the upper layer were formed under the conditions of invention examples of the lower layer formation type and the upper layer formation type having the same numbers as the condition type of invention example.

### Comparative examples:

For comparison, tool bodies (inserts) 1 to 4 made of WC-based cemented carbide manufactured in Example 1 were subjected to ultrasonic cleaning in acetone and were dried. The tool bodies 1 to 4 in this dried state were mounted along outer circumferential portions on a rotation table 110 in the AIP apparatus 100 shown in FIG. 2 at positions distant from the center axis thereof by predetermined distances in a radial direction thereof. The surface-coated inserts of comparative examples 1 to 6 (hereinafter, tools of comparative examples 1 to 6) shown in Table 7 were manufactured by the same method as in Example 1, except that the bombardment process conditions were changed.

Specific conditions are as follows.

Regarding the tools of comparative examples 1 to 4, as shown in conditions of comparative examples 1 to 4 in Table 5, while maintaining the conditions of the inside of the AIP apparatus 100 as the furnace inner atmosphere and the furnace inner pressure shown in Table 5, the tool body was heated by the heater 120 to a temperature shown in Table 5. Then, a DC bias voltage shown in Table 5 was applied to the tool body that was rotated while being revolved on the rotation table 110 by the bias electric power supply 130, and an arc current shown in Table 5 flowed between the target for metal ion bombardment and the anode electrode; and thereby, the arc discharge was generated. As described above, the surface of the tool body was subjected to the bombardment process.

In addition, regarding the tools of comparative examples 5 and 6, the bombardment process was performed under the conditions of comparative examples 5 and 6 of Table 5. The condition of comparative example 5 was within the range disclosed in Patent Document 2. In addition, the condition of comparative example 6 was within the range disclosed in the Patent Document 3. The film forming conditions of the upper layer after the bombardment process of the tools of comparative examples 1 to 4 and the tools of comparative examples 5 and 6 were as shown in Table 6.

In the condition type of comparative example 1, the lower layer and the upper layer were formed under the conditions of comparative examples of the lower layer formation type 1 and upper layer formation type 1. As described above, in each condition type of comparative example, the lower layer and the upper layer were formed under the conditions of comparative examples of the lower layer formation type and the upper layer formation type having the same numbers as the condition type of comparative example.

For the tools of invention examples 1 to 8 and the tools of comparative examples 1 to 6 manufactured as described above, a vertical section was cut out using a focused ion beam (FIB). The cross section was analyzed using an energy dispersive X-ray spectroscopy (EDS), an auger electron spectroscopy (AES), and an electron probe micro analyzer (EPMA) equipped with a scanning electron microscope (SEM) or a transmission electron microscope (TEM), and each component composition and each layer thickness of the A layer and the B layer of the upper layer were measured at five portions. An average composition and an average layer thickness were calculated from average values of the measured values.

For the W layer, the metal carbide layer, and the metal carbonitride layer of the lower layer, the composition of cross section were measured by the same analysis method as that of the upper layer. The method for obtaining the layer thickness of each layer of the lower layer is specifically described as follows. The vertical section of the tool was subjected to a line analysis of the composition along the normal direction (thickness direction of layer) of a body surface. By the line analysis, a curve was obtained in which a horizontal axis indicated a position in the thickness direction (distance from a certain reference position in the thickness direction) and a vertical axis indicated a content of each component (also referred to as a curve showing a change of content of each component in the thickness direction of the layer, a concentration profile of each component in the thickness direction of the layer). Based on this curve, the boundary of each layer was defined according to the following procedure.

First, in the curve showing the change of the W content in the thickness direction of the layer, the position where the increase of the W content started was set as the boundary between the tungsten carbide-based cemented carbide layer (WC layer) and the W layer. In addition, an intersection between a curve showing the change in W content in the thickness direction of the layer and a curve showing the change in content of the metal component constituting the metal carbide layer in the thickness direction of the layer was obtained, and the position of this intersection was set as the boundary between the W layer and the metal carbide layer. Further, in the curve showing the change of the N content in the thickness direction of the layer, the position where the increase of the N content started was set as the boundary between the metal carbide layer and the metal carbonitride layer. In addition, an intersection between a curve showing the change in content of the metal component constituting the metal carbonitride layer in the thickness direction of the layer and a curve showing the change in content of the metal component constituting the upper layer in the thickness direction of the layer was obtained, and the position of this intersection was set as the boundary between the metal carbonitride layer and the upper layer.

As described above, the boundary of each layer was determined with reference to the position where the W content started to increase, the position where the N content started to increase, and the intersections of the curves showing the changes in the contents of the respective metal components. The depth of the W layer, the thickness of the metal carbide layer, and the thickness of the metal carbonitride layer were determined from the positions of the boundaries between these layers.

Tables 4 and 7 show the measured and calculated values.

In the tables below, the x value of the A layer is the atomic ratio x in a case where the composition of the A layer is represented by the composition formula: (AlₓCr₁₋ₓ)N. The a value, b value, c value, and d value of the B layer are atomic ratios a, b, c, and d in a case where the composition of the B layer is represented by the composition formula: (Al_{1-a-b-c-d}TiₐCr_{b}Si_{c}Y_{d})N.

The compositions of the cathode electrodes (targets) shown in Tables 3 and 6 are shown in terms of atomic ratio (atom%).

**Table 1**

| Tool body type | Blending composition (mass%) | | | | | | |
|---|---|---|---|---|---|---|---|
| | Co | TiC | VC | TaC | NbC | Cr₃C₂ | WC |
| 1 | 5.5 | - | - | - | - | 0.8 | Balance |
| 2 | 8.0 | - | 0.5 | - | - | 0.5 | Balance |
| 3 | 9.7 | 4.2 | - | 5.0 | 2.5 | - | Balance |
| 4 | 12.0 | - | - | - | - | 1.0 | Balance |

**Table 2**

| Lower layer formation type | | Tool body symbol | Conditions of metal ion bombardment process | | | | | | |
|---|---|---|---|---|---|---|---|---|---|
| | | | Bombardment metal type | Temperature of tool body during bombardment process (°C) | Furnace inner atmosphere | Furnace inner pressure (Pa) | Bias voltage to tool body (V) | Arc current (A) | Bombardment process time (min) |
| Conditions of Invention Examples | 1 | 1 | Ti | 770 | Vacuum atmosphere | 8×10⁻⁴ | -1000 | 100 | 45 |
| | 2 | 2 | Ti | 780 | Vacuum atmosphere | 5×10⁻⁴ | -1000 | 100 | 35 |
| | 3 | 3 | Cr | 750 | Vacuum atmosphere | 1×10⁻³ | -1000 | 100 | 40 |
| | 4 | 4 | Ti | 760 | Vacuum atmosphere | 7×10⁻⁴ | -1000 | 100 | 30 |
| | 5 | 1 | Zr | 800 | Vacuum atmosphere | 1×10⁻⁴ | -1000 | 100 | 60 |
| | 6 | 2 | Nb | 780 | Vacuum atmosphere | 6×10⁻⁴ | -1000 | 100 | 48 |
| | 7 | 3 | Ta | 750 | Vacuum atmosphere | 4×10⁻⁴ | -1000 | 100 | 50 |
| | 8 | 4 | Hf | 790 | Vacuum atmosphere | 2×10⁻⁴ | -1000 | 100 | 55 |

**Table 3**

| Upper layer formation type | | Tool body symbol | Lower layer formation type | Cathode electrode (target) type | | Formation conditions of A layer | | | Formation conditions of B layer | | |
|---|---|---|---|---|---|---|---|---|---|---|---|
| | | | | For forming A layer | For forming B layer | Tool body temperature (°C) | Nitrogen partial pressure (Pa) | Bias voltage (-V) | Tool body temperature (°C) | Nitrogen partial pressure (Pa) | Bias voltage (-V) |
| Conditions of Invention Examples | 1 | 1 | 1 | Al50Cr50 | Al50Ti15Cr25Si7Y3 | 500 | 4.0 | -50 | 500 | 4.0 | -75 |
| | 2 | 2 | 2 | Al70Cr30 | Al50Ti24Cr20Si4Y2 | 500 | 6.7 | -50 | 500 | 4.0 | -150 |
| | 3 | 3 | 3 | Al70Cr30 | Al40Ti30Cr10Si10Y10 | 500 | 4.0 | -75 | 500 | 6.7 | -100 |
| | 4 | 4 | 4 | Al70Cr30 | Al55Ti20Cr20Si3 Y2 | 500 | 9.3 | -50 | 500 | 4.0 | -50 |
| | 5 | 1 | 5 | Al80Cr20 | Al50Ti6Cr40Y4 | 500 | 4.0 | -40 | 500 | 9.3 | -100 |
| | 6 | 2 | 6 | A140Cr60 | Al35Ti40Cr5Si15Y5 | 500 | 9.3 | -75 | 500 | 6.7 | -150 |
| | 7 | 3 | 7 | Al60Cr40 | Al44Ti10Cr25Si20Y1 | 500 | 6.7 | -30 | 500 | 6.7 | -125 |
| | 8 | 4 | 8 | Al50Cr50 | Al50Cr30Si12Y8 | 500 | 4.0 | -50 | 500 | 9.3 | -100 |

**Table 4**

| Type | | Condition type of Invention Example | Lower layer | | | | | Upper layer | | | | | | | |
|---|---|---|---|---|---|---|---|---|---|---|---|---|---|---|---|
| | | | Average depth of W layer (nm) | Metal carbide layer | | Metal carbonitride layer | | A layer | | B layer | | | | | Average total layer thickness of upper layer (µm) |
| | | | | Type | Average layer thickness (nm) | Type | Average layer thickness (nm) | Average layer thickness per one layer (µm) | x value | Average layer thickness per one layer (µm) | a value | b value | c value | d value | |
| Tools of Invention Examples | 1 | 1 | 220 | TiC | 160 | Ti(C,N) | 60 | 4.0 | 0.50 | 1.0 | 0.18 | 0.26 | 0.08 | 0.03 | 5.0 |
| | 2 | 2 | 170 | TiC | 120 | Ti(C,N) | 60 | 2.0 | 0.72 | 2.2 | 0.24 | 0.18 | 0.05 | 0.02 | 4.2 |
| | 3 | 3 | 10 | Cr₃C₂ | 5 | (AI,Cr)(C,N) | 5 | 4.9 | 0.69 | 1.2 | 0.31 | 0.10 | 0.11 | 0.09 | 6.1 |
| | 4 | 4 | 80 | TiC | 50 | Ti(C,N) | 40 | 1.0 | 0.70 | 4.1 | 0.20 | 0.21 | 0.03 | 0.02 | 5.1 |
| | 5 | 5 | 470 | ZrC | 400 | Zr(C,N) | 70 | 0.1 | 0.80 | 0.1 | 0.05 | 0.40 | 0 | 0.04 | 1.0 |
| | 6 | 6 | 320 | NbC | 70 | Nb(C,N) | 240 | 0.3 | 0.40 | 0.3 | 0.38 | 0.05 | 0.14 | 0.05 | 2.4 |
| | 7 | 7 | 290 | TaC | 230 | Ta(C,N) | 50 | 0.2 | 0.60 | 0.3 | 0.12 | 0.23 | 0.20 | 0.01 | 1.5 |
| | 8 | 8 | 360 | HfC | 220 | Hf(C,N) | 130 | 3.0 | 0.48 | 5.0 | 0 | 0.32 | 0.12 | 0.06 | 8.0 |

**Table 5**

| Lower layer formation type | | Tool body symbol | Conditions of metal ion bombardment process | | | | | | |
|---|---|---|---|---|---|---|---|---|---|
| | | | Bombardment metal type | Temperature of tool body during bombardment process (°C) | Furnace inner atmosphere | Furnace inner pressure (Pa) | Bias voltage to tool body (V) | Arc current (A) | Bombardment process time (min) |
| Conditions of Comparative Examples | 1 | 1 | Ti | 760 | Vacuum atmosphere | 7×10⁻⁴ | -1000 | 100 | 30 |
| | 2 | 2 | Ti | 770 | Vacuum atmosphere | 8×10⁻⁴ | -1000 | 100 | 45 |
| | 3 | 3 | Ti | 790 | Vacuum atmosphere | 5×10⁻⁴ | -1000 | 100 | 60 |
| | 4 | 4 | Ti | 780 | Vacuum atmosphere | 1×10⁻⁴ | -1000 | 100 | 35 |
| | 5 | 1 | Ti | 800 | Vacuum atmosphere | 8×10⁻³ | -800 | 120 | 4 |
| | 6 | 2 | Ti | 840 | H₂ + Ar | 0.08 | -1000 | 120 | 10 |

**Table 6**

| Upper layer formation type | | Tool body symbol | Lower layer formation type | Cathode electrode (target) type | | Formation conditions of A layer | | | Formation conditions of B layer | | |
|---|---|---|---|---|---|---|---|---|---|---|---|
| | | | | For forming A layer | For forming B layer | Tool body temperature (°C) | Nitrogen partial pressure (Pa) | Bias voltage (-V) | Tool body temperature (°C) | Nitrogen partial pressure (Pa) | Bias voltage (-V) |
| Conditions of Comparative Examples | 1 | 1 | 1 | Al70Cr30 | Al30Ti5Cr45Si5Y15 | 500 | 9.3 | -50 | 500 | 4.0 | -75 |
| | 2 | 2 | 2 | Al60Cr40 | Al50Ti20Cr20Si3Y7 | 500 | 4.0 | -50 | 500 | 4.0 | -150 |
| | 3 | 3 | 3 | Al45Cr55 | Al34.5Ti45Cr10Si10Y0.5 | 500 | 6.7 | -75 | 500 | 6.7 | -100 |
| | 4 | 4 | 4 | Al38Cr62 | Al54Ti10Cr30Si5Y1 | 500 | 4.0 | -30 | 500 | 6.7 | -50 |
| | 5 | 1 | 5 | Al50Cr50 | Al57Til5Cr3Si22Y3 | 500 | 9.3 | -50 | 500 | 4.0 | -50 |
| | 6 | 2 | 6 | Al85Cr15 | Al35Ti40Cr5Si15Y5 | 500 | 4.0 | -40 | 500 | 4.0 | -100 |

**Table 7**

| Type | | Condition type of Comparative Example | Lower layer | | | | | Upper layer | | | | | | | |
|---|---|---|---|---|---|---|---|---|---|---|---|---|---|---|---|
| | | | Average depth of W layer (nm) | Metal carbide layer | | Metal carbonitride layer | | A layer | | B layer | | | | | Average total layer thickness of upper layer (µm) |
| | | | | Type | Average layer thickness (nm) | Type | Average layer thickness (nm) | Average layer thickness per one layer (µm) | x value | Average layer thickness per one layer (µm) | a value | b value | c value | d value | |
| Tools of Comparative Examples | 1 | 1 | 70 | TiC | 50 | Ti(C,N) | 20 | *0.05 | 0.69 | 4.0 | 0.07 | *0.42 | 0.04 | *0.14 | 4.1 |
| | 2 | 2 | 240 | TiC | 150 | Ti(C,N) | 80 | 3.3 | 0.58 | *5.4 | 0.20 | 0.20 | 0.03 | 0.07 | *8.7 |
| | 3 | 3 | 480 | TiC | 310 | Ti(C,N) | 170 | 0.5 | 0.43 | *0.05 | *0.44 | 0.10 | 0.09 | *0.004 | 2.2 |
| | 4 | 4 | 160 | TiC | 130 | Ti(C,N) | 30 | *5.3 | *0.37 | 1.9 | 0.10 | 0.28 | 0.05 | 0.01 | 7.2 |
| | 5 | 5 | *4 | TiC | 5 | - | - | 3.1 | 0.50 | 1.2 | 0.15 | *0.03 | *0.23 | 0.03 | 4.3 |
| | 6 | 6 | 70 | TiC | 100 | - | - | 0.2 | *0.82 | 0.2 | 0.39 | 0.05 | 0.14 | 0.05 | *0.8 |

| | | | | | | | | | | | | | | | |
|---|---|---|---|---|---|---|---|---|---|---|---|---|---|---|---|
| A value with * indicates a value not satisfying the embodiment. | | | | | | | | | | | | | | | |

Next, each of the tools of invention examples 1 to 8 and the tools of comparative examples 1 to 6 was clamped to a tip portion of an insert holder of tool steel with a fixing jig. In this state, each of the tools was subjected to a wet continuous cutting test of a Ni-based heat resistant alloy under the following conditions (referred to as cutting conditions 1), and a wear width of flank face a cutting edge was measured.

### <Cutting conditions 1>

Work Material: a round bar of a Ni-based heat resistant alloy (Cr 19 mass%-Fe 19 mass%-Mo 3 mass%-Ti 0.9 mass%-Al 0.5 mass%-Ni balance)
Cutting speed: 100 m/min
Depth of cut: 0.5 mm
Feed: 0.15 mm/rev.
Cutting time: 10 minutes
Cutting fluid: water-soluble coolant

Table 8 shows the results thereof.

**Table 8**

| Type | | Cutting condition 1 | Type | | Cutting condition 1 |
|---|---|---|---|---|---|
| | | Wear width of flank face (mm) | | | Wear width of flank face (mm) |
| Tools of Invention Examples | 1 | 0.10 | Tools of Comparative Examples | 1 | *8 |
| | 2 | 0.07 | | 2 | 0.28 |
| | 3 | 0.16 | | 3 | 0.31 |
| | 4 | 0.08 | | 4 | 0.29 |
| | 5 | 0.15 | | 5 | *5 |
| | 6 | 0.13 | | 6 | *7 |
| | 7 | 0.11 | | | |
| | 8 | 0.13 | | | |

| | | | | | |
|---|---|---|---|---|---|
| (In the table, a value with * in the column of the comparative examples indicates cutting time (min) until the service life ended due to a reason such as peeling, adhesion, chipping, wear or the like. | | | | | |

### (Example 2)

Raw material powders having the blending composition shown in Table 1 were sintered under the conditions shown in Example 1 to form a round bar sintered body for forming a tool body having a diameter of 10 mm. By a grinding process, tool bodies (end mills) 1 to 4 made of WC-based cemented carbide having a 4-flute square shape with a helix angle of 30 degrees and having a dimension of diameter × length of the cutting edge portion to be 6 mm × 12 mm were manufactured respectively from the round bar sintered bodies.

Next, by using the tool bodies (end mills) 1 to 4, the surface-coated end mills 11 to 18 of the present embodiment (hereinafter, referred to as tools of invention examples 11 to 18) shown in Table 9 were manufactured by the steps as same as the steps (a) to (e) of Example 1 using the AIP apparatus 100.

For the tools of invention examples 11 to 18 manufactured as above, the average compositions and the average layer thicknesses of the W layer, the metal carbide layer, and the metal carbonitride layer of the lower layer were calculated by the same method as in Example 1. The average composition and the average layer thickness of each layer were also calculated for the A layer and the B layer of the upper layer.

Table 9 shows the measured and calculated values.

**Table 9**

| Type | | Condition type of Invention Example | Lower layer | | | | | Upper layer | | | | | | | |
|---|---|---|---|---|---|---|---|---|---|---|---|---|---|---|---|
| | | | Average depth of W layer (nm) | Metal carbide layer | | Metal carbonitride layer | | A layer | | B layer | | | | | Average total layer thickness of upper layer (µm) |
| | | | | Type | Average layer thickness (nm) | Type | Average layer thickness (nm) | Average layer thickness per one layer (µm) | x value | Average layer thickness per one layer (µm) | a value | b value | c value | d value | |
| Tools of Invention Examples | 11 | 1 | 200 | TiC | 130 | Ti(C,N) | 70 | 4.1 | 0.48 | 1.1 | 0.17 | 0.24 | 0.07 | 0.03 | 5.2 |
| | 12 | 2 | 160 | TiC | 120 | Ti(C,N) | 30 | 2.1 | 0.70 | 2.0 | 0.25 | 0.17 | 0.05 | 0.02 | 4.1 |
| | 13 | 3 | 10 | Cr₃C₂ | 6 | (Al,Cr)(C,N) | 5 | 5.0 | 0.69 | 1.1 | 0.29 | 0.11 | 0.10 | 0.09 | 6.1 |
| | 14 | 4 | 80 | TiC | 70 | Ti(C,N) | 20 | 1.0 | 0.71 | 3.8 | 0.22 | 0.19 | 0.03 | 0.02 | 4.8 |
| | 15 | 5 | 450 | ZrC | 380 | Zr(C,N) | 60 | 0.1 | 0.79 | 0.1 | 0.05 | 0.38 | 0 | 0.04 | 1.0 |
| | 16 | 6 | 300 | NbC | 60 | Nb(C,N) | 240 | 0.3 | 0.42 | 0.3 | 0.39 | 0.05 | 0.15 | 0.05 | 2.4 |
| | 17 | 7 | 310 | TaC | 240 | Ta(C,N) | 60 | 0.2 | 0.59 | 0.3 | 0.11 | 0.22 | 0.19 | 0.01 | 1.5 |
| | 18 | 8 | 340 | HfC | 230 | Hf(C,N) | 120 | 2.8 | 0.51 | 4.9 | 0 | 0.29 | 0.11 | 0.07 | 7.7 |

Next, the end mills of the tools of invention examples 11 to 18 were subjected to a shoulder cutting test of a Ni-based heat resistant alloy under the following conditions (referred to as cutting conditions 2) to measure the wear width of flank face of the cutting edge.

### <Cutting conditions 2>

Work Material: plate material of a Ni-based heat resistant alloy having plane dimensions of 100 mm × 250 mm and a thickness of 50 mm (Cr 19 mass%-Fe 19 mass%-Mo 3 mass%-Ti 0.9 mass%-Al 0.5 mass%-Ni balance)
Cutting speed: 40 m/min
Rotational speed: 2,100 min⁻¹
Depth of cut (ae): 0.3 mm
Depth of cut (ap): 6 mm
Feed rate (per tooth): 0.03 mm/tooth
Cutting length: 10 m

Table 10 shows cutting test results.

**Table 10**

| Type | | Cutting condition 2 |
|---|---|---|
| | | Wear width of flank face (mm) |
| Tools of Invention Examples | 11 | 0.11 |
| | 12 | 0.08 |
| | 13 | 0.15 |
| | 14 | 0.09 |
| | 15 | 0.16 |
| | 16 | 0.12 |
| | 17 | 0.10 |
| | 18 | 0.13 |

### (Example 3)

The round bar sintered bodies having a diameter of 10 mm manufactured in Example 2 as described above were used. By a grinding process, tool bodies (drills) made of WC-based cemented carbide having a 2-flute blade shape with a helix angle of 30 degrees and having a dimension of diameter × length of a groove forming portion to be 6 mm × 30 mm were manufactured from these round bar sintered bodies.

Next, the cutting edges of these tool bodies (drills) were subjected to honing and ultrasonic cleaning in acetone, and then were dried.

Next, each of the resultant tool bodies was loaded on the AIP apparatus 100, and surface-coated drills 21 to 28 of the present embodiment (hereinafter, referred to as tools of invention examples 21 to 28) including the lower layer and the upper layer shown in Table 11 were manufactured under the same conditions as in Example 1.

For the tools of invention examples 21 to 28 manufactured as described above, the average compositions and the average layer thicknesses of the W layer, the metal carbide layer, and the metal carbonitride layer of the lower layer were calculated by the same method as in Example 1. The average composition and the average layer thickness of each layer were also calculated for the A layer and the B layer of the upper layer.

Table 11 shows the measured and calculated values.

**Table 11**

| Type | | Condition type of Invention Example | Lower layer | | | | | Upper layer | | | | | | | |
|---|---|---|---|---|---|---|---|---|---|---|---|---|---|---|---|
| | | | Average depth of W layer (nm) | Metal carbide layer | | Metal carbonitride layer | | A layer | | B layer | | | | | Average total layer thickness of upper layer (µm) |
| | | | | Type | Average layer thickness (nm) | Type | Average layer thickness (nm) | Average layer thickness per one layer (µm) | x value | Average layer thickness per one layer (µm) | a value | b value | c value | d value | |
| Tools of Invention Examples | 21 | 1 | 220 | TiC | 140 | (Al,Ti)(C,N) | 80 | 4.2 | 0.51 | 1.0 | 0.18 | 0.25 | 0.08 | 0.02 | 5.2 |
| | 22 | 2 | 170 | TiC | 130 | Ti(C,N) | 40 | 2.0 | 0.69 | 2.1 | 0.24 | 0.18 | 0.06 | 0.03 | 4.1 |
| | 23 | 3 | 10 | Cr₃C₂ | 7 | (Al,Cr)(C,N) | 5 | 4.9 | 0.68 | 1.2 | 0.32 | 0.11 | 0.09 | 0.10 | 6.1 |
| | 24 | 4 | 90 | TiC | 60 | Ti(C,N) | 30 | 0.9 | 0.70 | 4.1 | 0.21 | 0.21 | 0.03 | 0.02 | 5.0 |
| | 25 | 5 | 460 | ZrC | 390 | Zr(C,N) | 80 | 0.1 | 0.80 | 0.1 | 0.05 | 0.39 | 0 | 0.04 | 1.0 |
| | 26 | 6 | 330 | NbC | 90 | Nb(C,N) | 240 | 0.3 | 0.41 | 0.3 | 0.38 | 0.05 | 0.15 | 0.06 | 2.4 |
| | 27 | 7 | 290 | TaC | 230 | Ta(C,N) | 50 | 0.2 | 0.62 | 0.3 | 0.09 | 0.23 | 0.20 | 0.01 | 1.5 |
| | 28 | 8 | 380 | HfC | 260 | Hf(C,N) | 130 | 3.1 | 0.47 | 4.8 | 0 | 0.31 | 0.12 | 0.07 | 7.9 |

Next, the tools of invention examples 21 to 28 were subjected to a wet drilling cutting test of a Ni-based heat resistant alloy under the following conditions (referred to as cutting conditions 3) to measure the wear width of flank face of the cutting edge, in a case where the number of holes was set to be 30.

### <Cutting conditions 3>

Work Material: plate material of a Ni-based heat resistant alloy having plane dimensions of 100 mm × 250 mm and a thickness of 50 mm (Cr 19 mass%-Fe 19 mass%-Mo 3 mass%-Ti 0.9 mass%-Al 0.5 mass%-Ni balance)
Cutting speed: 13.7 m/min
Feed: 0.06 mm/rev.
Hole depth: 12 mm

Table 12 shows cutting test results.

**Table 12**

| Type | | Cutting condition 3 |
|---|---|---|
| | | Wear width of flank face (mm) |
| Tools of Invention Examples | 21 | 0.10 |
| | 22 | 0.09 |
| | 23 | 0.16 |
| | 24 | 0.08 |
| | 25 | 0.15 |
| | 26 | 0.13 |
| | 27 | 0.11 |
| | 28 | 0.12 |

From the results shown in Table 8, Table 10, and Table 12, it was found that with regard to the tools of invention examples 1 to 8, 11 to 18, and 21 to 28, peeling did not occur during high-speed cutting work of a Ni-based heat resistant alloy in which high-temperature heat was generated and great thermal loads and mechanical loads were exerted to a cutting edge. In addition, abnormal damage such as adhesion, chipping, and fracture did not occur and excellent wear resistance was exhibited during long-term use.

On the other hand, in the tools of comparative examples 1 to 6, peeling, chipping, fracture, and the like occurred due to thermal loads and mechanical loads exerted to the cutting edge during the cutting. Moreover, the life was short.

### Industrial Applicability

As described above, the coated tool of the present embodiment exhibits excellent cutting performance for a long period of time in a case of being used in high-speed cutting work of a Ni-based heat resistant alloy. It can also be applied to high-speed cutting work of Co-based heat resistant alloys and Fe-based heat resistant alloys, in addition to the Ni-based heat resistant alloy, and it can be said to be a general-purpose cutting tool.

### Explanation of Reference Signs

- 1: Surface-coated cutting tool (coated tool)
- 10: Tool body
- 20: Lower layer
- 21: W layer
- 22: Metal carbide layer
- 23: Metal carbonitride layer
- 30: Upper layer
- 31: A layer
- 32: B layer

## Claims

1. A surface-coated cutting tool comprising:
a tool body including a tungsten carbide-based cemented carbide;
a lower layer provided on the tool body; and
an upper layer provided on a surface of the lower layer and having an alternate laminated structure, wherein
(a) the lower layer consists of a W layer, a metal carbide layer, and a metal carbonitride layer,
(b) the W layer is formed from a surface of the tool body to an inside thereof over the surface to a depth of 10 to 500 nm,
(c) a metal in the metal carbide layer is any one selected from the group consisting of Ti, Cr, Zr, Hf, Nb, and Ta, the metal carbide layer has an average layer thickness of 5 to 500 nm, and the metal carbide layer is formed directly on the W layer,
(d) the metal carbonitride layer includes a metal component contained in the metal carbide layer, the metal carbonitride layer has an average layer thickness of 5 to 300 nm, and the metal carbonitride layer is formed directly on the metal carbide layer,
(e) the upper layer has an alternate laminated structure in which at least one A layer and at least one B layer are alternately laminated, and the upper layer has an average total layer thickness of 1.0 to 8.0 µm,
(f) the A layer is a composite nitride layer of Al and Cr, the A layer has an average layer thickness of 0.1 to 5.0 µm per one layer, and the A layer has an average composition satisfying 0.40 ≤ x ≤ 0.80 (where x is an atomic ratio), in a case where a composition of the A layer is represented by a composition formula: (AlₓCr₁₋ₓ)N, and
(g) the B layer is a composite nitride layer of Al, Ti, Cr, Si, and Y, the B layer has an average layer thickness of 0.1 to 5.0 µm per one layer, and the B layer has an average composition satisfying 0 ≤ a ≤ 0.40, 0.05 ≤ b < 0.40, 0 ≤ c ≤ 0.20, and 0.01 ≤ d ≤ 0.10 (where, all of a, b, c, and d are atomic ratios), in a case where a composition of the B layer is represented by a composition formula: (Al_{1-a-b-c-d}TiₐCr_{b}Si_{c}Y_{d})N.

2. The surface-coated cutting tool according to claim 1,
wherein the surface-coated cutting tool is any one of a surface-coated insert, a surface-coated end mill, and a surface-coated drill.

3. The surface-coated cutting tool according to claim 1 or 2,
wherein the surface-coated cutting tool is a cutting tool for cutting a Ni-based heat resistant alloy at a high speed.
